# EUROPEAN PATENT SPECIFICATION

(11) **EP 3 471 152 B1**
(45) Date of publication and mention of the grant of the patent: **02.12.2026**
(21) Application number: 17196120.4
(22) Date of filing: 12.10.2017
(51) Int. Cl.: H10F 55/255, G01S 7/481

(54) **METHOD FOR FABRICATING A PLURALITY OF TIME-OF-FLIGHT SENSOR DEVICES**
VERFAHREN ZUR HERSTELLUNG EINER VIELZAHL VON LAUFZEITMESSUNGS-SENSORVORRICHTUNGEN
PROCÉDÉ DE FABRICATION D'UNE PLURALITÉ DE DISPOSITIFS DE DÉTECTION DE DURÉE DE VOL

(43) Date of publication of application: 17.04.2019
(73) Proprietor: ams-OSRAM AG, 8141 Premstätten (AT)
(72) Inventor: Etschmaier, Harald, 8054 Graz (AT); Bodner, Thomas, 8054 Seiersberg (AT)
(74) Representative: Epping - Hermann - Fischer

(56) References cited:
- WO-A1-2017/142487
- US-A1- 2013 099 101
- US-A1- 2015 083 900
- US-A1- 2017 287 886

## Description

### Technical Field

The disclosure relates to a method for fabricating a plurality of Time-of-Flight sensor devices. The disclosure further relates to a Time-of-Flight sensor device fabricated by the method.

### Background

Time-of-Flight (TOF) distance measurement is based on measuring the time duration between two events, such as when a signal leaves a range finder and when it is received again after reflection at a target. The time between the event of emitting the signal and the event of receiving the reflected signal is directly proportional to the distance between the range finder and the target. The precision of the distance measurement is directly proportional to the precision of the time measurement.

There is a desire to provide a method for fabricating a plurality of Time-of-Flight sensor devices, wherein the method enables to produce a large number of devices in a short time with a low number of processing steps.

The document US2015083900 A1 discloses an example of known encapsulation of a Time of Flight sensor device.

### Summary

An embodiment of a method for fabricating a plurality of Time-of-Flight sensor devices is specified in claim 1.

According to the method for fabrication the plurality of Time-of-Flight sensor devices, a wafer is provided, wherein said wafer includes a plurality of wafer portions for a respective one of the Time-of-Flight sensor devices. Each of the wafer portions includes a first light detecting area and a second light detecting area, wherein at least the second light detecting area is arranged in a surface of the respective wafer portion.

A respective light emitter device is disposed on each of the wafer portions. The respective light emitter device and the respective first light detecting area are arranged so that portions of the light emitted by the respective light emitter device are detected by the respective first light detecting area. The respective light emitter device and the respective first light detecting area are encapsulated by a first volume of a light transparent material. The respective second light detecting area is encapsulated by a second volume of the light transparent material. The first and the second volume of the light transparent material are separated from each other. An opaque material is placed on the wafer portions in a space between the respective first and second volume of the light transparent material. The wafer is diced between adjacent ones of the wafer portions to separate the wafer into the plurality of the Time-of-Flight sensor devices.

The method allows to produce a wafer level package for a TOF sensor system. In particular, the method and the Time-of-Flight sensor device manufactured by the method provide an optical reference path, which is necessary for a functional TOF sensor system, on wafer level, instead of relying on an electronic signal for starting a timer. The optical reference path is provided between the light emitter device and the first light detecting area. The first light detecting area is disposed close to the light emitter device so that scattered light emitted from the light emitter device is received from the first light detecting area.

The optical reference path between the light emitter device and the first light detecting area allows to improve accuracy of the time measurement, because an electronic signal for starting a timer when a light signal is emitted from the light emitter device is not necessary. The timer which starts to count when light is emitted from the light emitter device is started when the scattered light of the light emitter device is received from the first light detecting area via the optical reference path.

A vertical cavity surface-emitting laser (VCSEL) may be used as a light emitter device. The first and the second light detecting area may be realized by two single photon avalanche diode (SPAD) arrays on a single die. The first light detecting area serves as a detector for a reference signal, for example, for detecting the scattered light emitted from the light emitter device. When the scattered light is received from the first light detecting area a timer starts to count the time until the signal reflected at a target is received from the second light detecting area.

In order to differentiate between the reference signal received at the first light detecting area and the measurement/reflected signal at the second light detecting area, the light detecting areas have to be optically isolated so that it is ensured that the first light detecting area only receive an optical signal coming directly from the light emitter device, and the second light detecting area receives and detects an optical signal after reflection at the target. To this purpose, the two light detecting areas are optically isolated by the opaque material that serves as an optical barrier between the light emitter device and the second light detecting area.

According to a possible embodiment of the method for fabricating the plurality of Time-of-Flight sensor devices, the respective first and second volume of the light transparent material are provided on the surface of each wafer portion by a Nano Imprint Lithography (NIL) process. An imprint mold having a plurality of pairs of a first and second cavity is provided. The first and the second cavity of each pair of the cavities is filled with the light transparent material. The imprint mold is then placed on a surface of the wafer so that each pair of the first and second cavity, with the light transparent material included, is placed over a respective one of the wafer portions.

In particular, the imprint mold is disposed above the wafer so that the first cavity of each pair of cavities of the imprint mold is placed over the light emitter device and the first light detecting area. The second cavity of each pair of the first and second cavity of the imprint mold is placed above the second light detecting area. Due to the distance between the first and second cavity of the imprint mold the first volume of the light transparent material which has been provided and formed by the first cavity of the imprint mold and the second volume of the light transparent material which has been provided and formed by the transparent material included in the second cavity of the imprint mold are spatially separated from each other.

In order to place the opaque material on the wafer portions in the space between the respective first and second volume of the light transparent material, a wafer-level molding (WLM) process may be used. In particular, the opaque material which forms the optical barrier between the first and the second volume of the light transparent material and thus between the first and the second light detecting area can be made by film assisted wafer-level molding.

In this technology, a body of a mold tool is covered by a soft film, for example a PTFE film and clamped on the wafer surface. The film seals the contact areas between the mold tool and the wafer or the upper surface of the first and second volume of the light transparent material. The film is pressed to the upper surface of the respective first and second volume of the light transparent material of each wafer portion so that the upper surface of the respective first and second volume of the light transparent material is sealed by the film. The opaque material can now be injected in the space between the film and the surface of the wafer portions. The respective upper surface of the first and second volume of the light transparent material of each wafer portion is kept free of the mold compound/opaque material.

Before singulation of the wafer, electrical connections are attached to the backside/ lower surface of each wafer portion. The electrical connections may be configured as solder balls. The electrical connections are provided to connect each Time-of-Flight sensor device to a circuit board.

The proposed manufacturing process flow combines the technologies of Nano Imprint Lithography (NIL) and wafer-level molding (WLM). The complete assembly process is carried out on a wafer level prior to singulation. The wafer-level processing reduces assembly costs. The manufacturing method allows to produce a chip scale emitter/receiver package for a Time-of-Flight sensor with a reduced footprint compared to conventional LGA packages. The wafer-level chip scale package for the Time-of-Flight sensor manufactured by the proposed method comprises integrated lenses which improve product performance and offer "multi-zone" functionality. The integrated lenses are formed by the respective first and second volume of the light transparent material of each wafer portion. In particular, the integrated lenses do not only enable a resolution in one direction, for example the z-direction, but also a resolution in other directions, for example the x- and y-direction.

Additional features and advantages are set forth in the detailed description that follows, and in part will be readily apparent to those skilled in the art from the description or recognized by practicing the embodiments as described in the written description and claims hereof, as well as the appended drawings. It is to be understood that both the foregoing general description and the following detailed description are merely exemplary, and are intended to provide an overview or framework to understand the nature and character of the claims.

### Brief description of the drawings

- Figure 1: shows an embodiment of a Time-of-Flight sensor device having a wafer-level chip scale package;
- Figure 2: illustrates an arrangement of a light emitter device and light detecting areas on a silicon wafer for fabricating a Time-of-Flight sensor device;
- Figure 3: illustrates a wafer-level manufacturing step of Nano Imprint lithography in which cavities of an imprint mold are filled with a light transparent material for forming first and second volumes of the light transparent material on wafer portions of a wafer;
- Figure 4: illustrates a wafer-level manufacturing step in which the light transparent material for the first and second volume of the light transparent material is cured;
- Figure 5: illustrates a wafer-level manufacturing step of wafer-level molding in which a mold tool forms a space between a surface of the wafer and a film of the mold tool that covers a respective upper surface of the first and second volume of the light transparent material;
- Figure 6: illustrates a wafer-level manufacturing step of wafer-level molding in which an opaque material is injected in a space between a wafer surface and a film of the mold tool and cured; and
- Figure 7: illustrates a wafer-level manufacturing step in which external connections are mounted to a backside of the wafer before the individual wafer portions of the wafer are singulated.

### Detailed description

Embodiments of the method for fabricating a plurality of Time-of-Flight sensor devices and a Time-of-Flight sensor device manufactured by the method are now be described more fully hereinafter with reference to the accompanying drawings. The manufacturing method and the Time-of-Flight sensor device may, however, be embodied in many different forms and should not be construed as limited to the embodiments set forth herein; rather, these embodiments are provided so that the disclosure will fully convey the scope of the manufacturing method and the Time-of-Flight sensor device to those skilled in the art. The drawing are not necessarily drawn to scale but are configured to clearly illustrate the different embodiments of the manufacturing method and the Time-of-Flight sensor device.

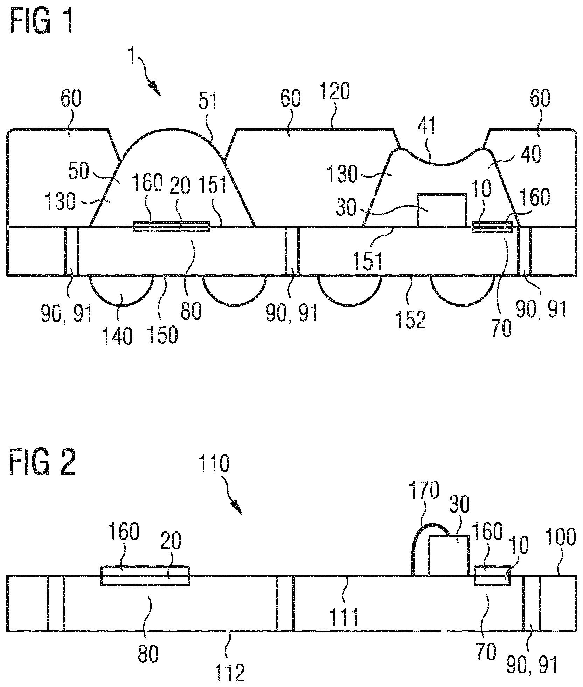

Figure 1 shows an embodiment of a Time-of-Flight sensor device 1 having a chip scale emitter/receiver package which is manufactured on wafer level. The Time-of-Flight sensor device 1 comprises a die 150 with at least an integrated circuit on its top surface 151. The die 150 may be configured as a portion, for example a silicon die, that has been singularized from a silicon wafer. The die 150 includes a light detecting area 10 and a light detecting area 20 being arranged in/on the surface 151 of the silicon die 150. The light detecting areas 10 and 20 may be respectively configured as two spatially separated SPAD (single photon avalanche diode) arrays.

The Time-of-Flight sensor device 1 further comprises a light emitter device 30 being arranged on the same surface 151 of the silicon die 150. The light emitter device 30 may be configured as a VCSEL (vertical cavity surface emitting laser). The purpose of the light detecting area 10 is to detect the emission of light emitted by the light emitter device 30. The light detecting area 10 may be configured to detect the emission of a laser pulse, if the light emitter device 30 is embodied to emit laser light pulses. The light detecting area 20 is configured to detect the return of the emitted light after being reflected at a target. In particular, the light detecting area 20 may be configured to detect a reflected laser pulse previously emitted by the light emitter device 30 and being reflected at a target.

The light emitter device 30 is arranged/stacked on the surface 151 of the silicon die 150 in relation to the light detecting area 10 such that portions of the light emitted by the light emitter device 30 are detected by the light detecting area 10. According to a possible embodiment of the Time-of-Flight sensor device, the light emitter device 30 and the light detecting area 10 may be arranged close/next to each other so that the portions of the light emitted by the light emitter device 30 are detected by the light detecting area 10. This embodiment is shown in Figure 1**.**

According to another embodiment, the light emitter device 30 and the light detecting area 10 may be arranged on top of each other on the wafer 100 so that the portions of the light emitted by the light emitter device 30 may be detected by the light detecting area 10. In particular, the light emitter device 30 may be arranged on the surface 151 of the silicon die 150 so that the light emitter device 30 covers the light detecting area 10.

Both embodiments ensure a direct light path from the light emitter device 30 to the reference light detecting area 10. The purpose of the light detecting area/array 10 is to detect the time of the emission of light emitted by the light emitter device 30, for example the emission of a laser pulse. The light detecting area 20 is provided to detect the time of the return of the reflected laser pulse previously emitted by the light emitter device 30. One or both of the light detecting areas 10 and 20 may be covered by an optical bandpass filter 160, as shown in Figure 1. This configuration enables to reduce the effect of ambient light to the light detecting areas 10 and 20. The optical filter 160 may be configured as a structured, dielectric interference filter.

Through silicon vias 90 are provided in the silicon die 150 and filled with an electrically conductive material 91. Electrically contacts are brought from the front surface 151 of the silicon die to the backside 152 of the silicon die by the metallized through silicon vias 90.

The Time-of-Flight sensor device comprises an integrated circuit 70 coupled to the light detecting area 10 to convert an optical signal received from the light detecting area 10 in a first electrical signal. The Time-of-Flight sensor device 1 further comprises an integrated circuit 80 coupled to the light detecting area 20 to convert an optical signal received from the light detecting area 20 in a second electrical signal. The integrated circuits 70 and 80 may be optoelectronic circuits being integrated in the silicon die 150. In order to electrically connect the integrated circuits 70 and 80 external connections 140, for example solder balls, are arranged on the lower surface/backside 152 of the silicon die 150.

The two light detecting areas 10 and 20 are covered by separate volumes 40 and 50 of a light transparent material 130, for example a clear epoxy resin or silicone. A first volume 40 of a light transparent material 130 is placed on the surface 151 of the silicon die 150 so that the light emitter device 30 and the light detecting area 10 are encapsulated by the volume 40 of the light transparent material 130. A second volume 50 of a light transparent material 130 is placed on the surface 151 of the silicon die 150 so that the light detecting area 20 is encapsulated by the volume 40 of the light transparent material. The volumes 40 and 50 of the light transparent material 130 are separated from each other.

The upper/top surfaces 41 and 51 of the volumes 40 and 50 can be shaped to achieve optical functionality. In particular, the surfaces 41 and 51 may be shaped such that the volumes 40 and 50 are embodied as optical lenses. The surface 41 of the volume 40 of the light transparent material 130 may be configured as a concave lens. The lens 40 being arranged over the light emitter device 30 is advantageously of concave shape to widen its field of emission and thus the field of view of the sensor. Regarding the volume 50, it is preferred to form the surface 51 of the volume 50 of the light transparent material 130 such that the volume 50 of the light transparent material is configured as a convex lens. The convex lens on top of the measurement light detecting area 20 serves as an imaging lens, which enables the system to resolve laterally spaced objects.

As shown in Figure 1, an opaque material 60 is disposed in a space 120 between the volume 40 and 50 of the light transparent material 130 such that the upper surface 41 of the volume 40 of the light transparent material and the upper surface 51 of the volume 50 of the light transparent material 130 is free from the opaque material 60. The remaining portions, i.e. the lower portions of the volume 40 and 50 of the light transparent material 130 are embedded in the opaque material 60. The opaque material 60 serves as an optical barrier to prevent emitted light from the light emitter device 30 directly reaching the measurement light detecting area 20. Only light which has been reflected by another object can reach the measurement light detecting area 20.

In order to create the opaque material, an absorbing additive like carbon black can be added to the transparent material 130, for example an epoxy resin or silicone. Preferably, the opaque material 60 completely surrounds the clear/light transparent material 130 and covers all of the surface 151 of the die 150 that is not covered by the light transparent material 130. Only the top part of the lenses 40 and 50, i.e. the upper surfaces 41 and 51 of the lenses, remain uncovered, as shown in Figure 1. In this configuration, the opaque material 60 works as an aperture for the lenses 40, 50 and protects the sensitive die surface 151 from environmental stresses
Figures 2 to 7 illustrate method steps of a manufacturing method to fabricate the Time-of-Flight sensor device 1. All method steps are performed on wafer level so that the individual components of the Time-of-Flight sensor devices do not need to be assembled individually for each unit. Thus, the described manufacturing process is fast and the assembly costs are low. Figures 2 to 7 only show one of a plurality of wafer portions 110 to realize one of the Time-of-Flight sensor devices.

Figure 2 illustrates a manufacturing step for fabricating a plurality of Time-of-Flight sensor devices, wherein a wafer 100 including a plurality of wafer portions 110 for a respective one of the Time-of-Flight sensor devices 1 is provided. Each of the wafer portions 110 includes a light detecting area 10 and a light detecting area 20 being arranged in/on a surface 111 of the respective wafer portion 110.

The wafer 100 is made of a silicon material. Each of the wafer portions 110 of the wafer 100 includes a respective integrated circuit 70 coupled to the respective light detecting area 10 to convert an optical signal of the light detecting area 10 in an electrical signal. Furthermore, each of the wafer portions 110 of the wafer 100 includes a respective integrated circuit 80 coupled to the respective light detecting area 20 to convert an optical signal of the light detecting area 20 into an electrical signal. The integrated circuits 70 and 80 may be configured as optoelectronic circuits which are integrated in each of the wafer portions 110.

A respective light emitter device 30 is disposed on each of the wafer portions 110. As explained above, the light emitter device 30 may be configured as a VCSEL to emit light, for example laser pulses, to a target. The stacking of the light emitter device 30, for example the VCSEL, is done on wafer level to maximize efficiency. The light emitter device 30 may be used in various contact configurations. The light emitter devices, for example the VCSELs, are available in various contact configurations: double top contact, top and bottom contact or double bottom contact. For top contacts the electrical connection to the circuitry on the chip is made by wire bonding, whereas in the case of the light emitter device 30 having bottom contacts, the bottom contacts may be soldered or glued to the surface 151 of the silicon die 150.

A die bonder can be used to attach the light emitter device 30 to the surface 111 of each of the wafer portions 110 of the wafer 100. As shown in Figure 2, the top surface of the light emitter device 30 may be electrically connected to the surface 111 of each of the wafer portions 110 by a wire 170 which is set with a wire bonder. For bottom contact light emitter devices 30, it is sufficient to establish the electrical connection by an electrically conductive glue or solder which connects the bottom surface of the light emitter device 30 to the surface 111 of the respective wafer portion 110 of the wafer 100.

The light emitter device 30 is configured to emit light to a target that reflects the light. The light detecting area 10 receives the light directly emitted from the light emitter device 30. The reflected light is received by the light detecting area 20. In order to determine a distance between the Time-of-Flight sensor device and the target, the time duration between the emission of the light and the receiving of the reflected light is determined.

The respective light emitter device 30 and the respective light detecting area 10 are arranged on the surface 111 of the wafer portion 110 so that portions of the light emitted by the respective light emitter device 30 are detected by the respective light detecting area 10 via a direct optical path.

In order to provide the optical path to directly receive the light emitted by the light emitter device 30, for example scattered light of the light emitter device 30, the respective light emitter device 30 and the respective light detecting area 10 of each wafer portion 110 are arranged close/next to each other, as shown in Figure 2.

According to another configuration, the respective light emitter device 30 and the respective light detecting area 10 of each wafer portion 110 are arranged on top of each other so that portions of the light emitted by the respective light emitter device 30 are detected by the respective light detecting area 10 of each of the wafer portions 110. The respective light emitter device 30 may be arranged, for example, above the respective light detecting area 10 to cover the respective light detecting area 10 of each of the wafer portions 110.

As illustrated in Figure 2, according to a possible embodiment, one or both of the light detecting areas 10 and 20 may be covered by an optical filter 160, for example an optical bandpass filter, in order to reduce the effect of ambient light.

Respective through-silicon vias 90 which are filled with an electrically conductive material 91 may be provided in the material of each of the wafer portions 110 to provide an electrical connection from the surface/upper side 111 of each of the wafer portions to the backside 112 of each of the wafer portions 110.

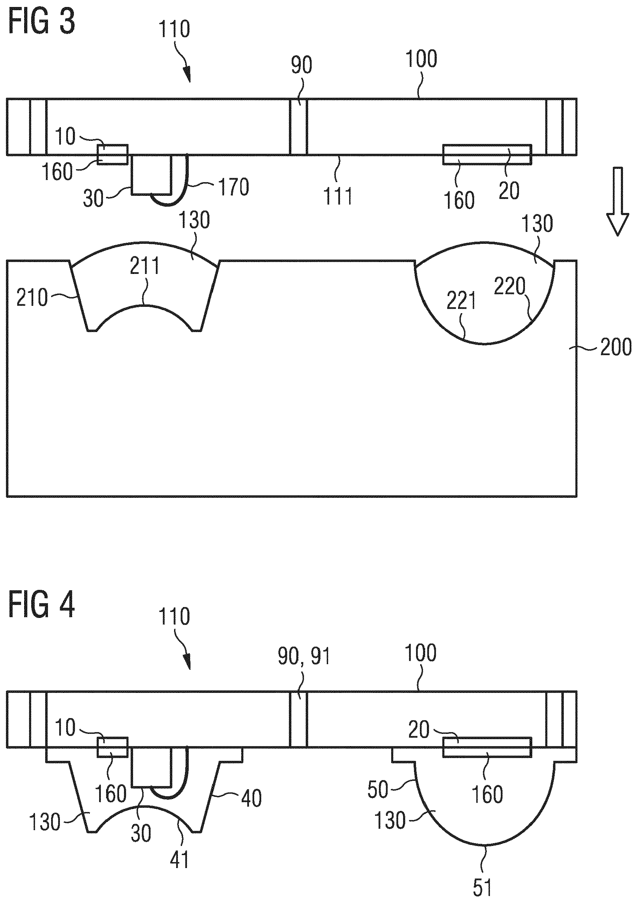

The volumes 40 and 50 of the light transparent material 130 are provided on the surface 111 of each of the wafer portions 110 by a Nano Imprint lithography (NIL) process. The NIL-process is illustrated in Figures 3 and 4. In particular, Figures 3 and 4 illustrate the manufacturing step of encapsulating the respective light emitter device 30 and the respective light detecting area 10 of each of the wafer portions 110 by the volume 40 of the light transparent material 130, and the step of encapsulating the respective light detecting area 20 by the volume 50 of the light transparent material 130, wherein the volumes 40 and 50 of the light transparent material are separated from each other.

As shown in Figure 3, an imprint mold/master stamp 200 having a plurality of pairs of a first and a second cavity 210, 220 is provided. Each pair of the first and the second cavity 210, 220 is associated with a respective one of the wafer portions 110 or Time-of-Flight sensor devices 1.

The imprint mold/master 200 can be made from UV-transparent materials such as PMMA or PDMS. The first and the second cavity 210, 220 of each pair of the first and the second cavity is filled with the light transparent material 130. In particular, in the cavities 210, 220, a clear, UV or heat-curable compound can be dispensed. Then, the imprint mold 200 is brought in contact with the surface 111 of each of the wafer portions 110. In particular, the imprint mold 200 is placed on the wafer 100 so that each pair of the first and the second cavities 210 and 220 is placed over a respective one of the wafer portions 110.

Each pair of the first and the second cavity 210 and 220 of the imprint mold 200 is placed over a respective one of the wafer portions 110 such that the light transparent material 130 filled in the first cavity 210 of the respective pair of the first and second cavity of the imprint mold 200 is placed above the respective light detecting area 10 and the light emitter device 30 to form the volume 40 of the light transparent material 130. Furthermore, each pair of the first and the second cavity 210 and 220 of the imprint mold 200 is placed over a respective one of the wafer portions 110 such that the transparent material filled in the second cavity 220 of the respective pair of the first and second cavity of the imprint mold 200 is placed above the respective light detecting area 20 to form the volume 50 of the light transparent material 130.

To form the volumes 40 and 50 of the light transparent material as lenses on the respective surface 111 of each of the wafer portions 110, the imprint mold/master stamp 200 carries the negative shape of the lenses 40, 50 in the form of the first and second cavities 210, 220 in its surface.

The respective surface 211, 221 at the bottom of the first and the second cavity 210, 220 of each pair of the first and second cavity of the imprint mold 200 has a shape so that the first and the second volume 40 and 50 of the light transparent material 130 is formed as a lens. In particular, the respective first cavity 210 of each pair of the first and the second cavity of the imprint mold 200 is shaped such that the volume 40 of the light transparent material 130 is formed having a concave shape to realize a concave lens. Furthermore, the respective second cavity 220 of each pair of the first and the second cavity of the imprint mold 200 is shaped such that the volume 50 of the light transparent material 130 is formed having a convex shape to realize a convex lens.

Figure 4 shows the wafer configuration after the volume 40 of the light transparent material 130 is placed on the surface 111 of each wafer portion 110 to encapsulate the light emitter device 30 and the light detecting area 10/optical filter 160, and after placing the volume 50 of the light transparent material 130 over the light detecting area 20/optical filter 160 of each of the wafer portions 110.

The transparent material 130 is cured in the first and second cavity 210 and 220 of each pair of the cavities 210, 220 to form the respective first and second volume 40 and 50 of the light transparent material 130. The manufacturing method using the Nano Imprint lithography enables the manufacturing of completely isolated lenses 40 and 50 without the need for runners. In the case of lens forming using wafer-level molding, runner gates need to be removed in an additional process step. However, according to the proposed solution, no portion of the transparent encapsulant 130 has to be removed to form the spatially separated volumes/lenses 40 and 50.

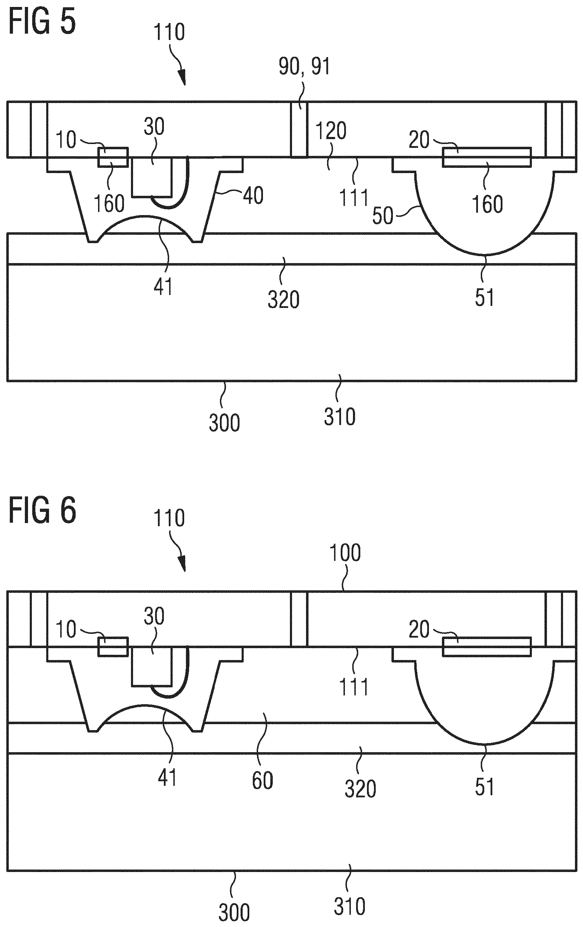

Figures 5 and 6 illustrate the manufacturing step of placing the opaque material 60 on the wafer portions 110 in a space 120 between the respective volumes 40 and 50 of the light transparent material 130 of each wafer portion 110. The opaque material 60 is placed on the respective wafer portions 110 of the wafer 100 by a wafer-level molding process. In particular, the wafer-level molding process may be a film assisted wafer-level molding process.

In order to apply the film assisted wafer-level molding process to dispose the opaque compound 60 on the surface 111 of each wafer portion 110, a mold tool 300 having a body 310 which is covered by a soft film 320 is provided. The soft film 320 may be configured as a PTFE-film. As shown in Figure 5, the mold tool 300 is placed above the wafer 100 such that a respective upper surface 41, 51 of the volume 40 and 50 of the light transparent material 130 is covered by the film 320. The mold tool 300 is placed above the wafer 100 such that a space 120 is provided between the film 320 and the surface 111 of the respective wafer portions 110.

The opaque material 60 is injected in the space 120 between the film 320 and the surface 111 of the respective wafer portions 110 via molding before singulation, i.e. still on wafer-level. The film 320 seals the respective upper surface 41, 51 of the volume 40 and 50 of the light transparent material 130 so that the respective upper surface 41, 51 of the volume 40 and 50 of the light transparent material is kept free of the opaque material 60. The opaque mold 60 is added without the need to form grooves, and without the need to remove the material above the apertures, thus significantly simplifying the method.

The mold tool 300 can have a specific shape to achieve a certain surface geometry of the device. According to a possible embodiment, the mold tool 300 can have a flat surface, as shown in Figures 5 and 6, which has the advantage that alignment is uncritical.

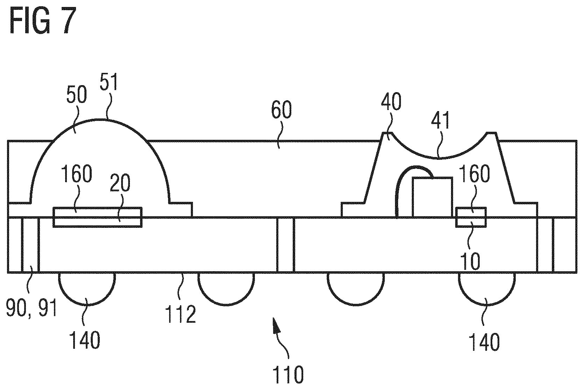

Figure 7 illustrates the manufacturing step of providing external connections 140, for example solder balls, to electrically connect the light detecting areas 10 and 20, the light emitter device 30 and the integrated optoelectronic circuits 70 and 80. The electrical connection can be provided by mounting solder balls 140 to the bottom surface 112 of each wafer portion 110.

In a last manufacturing step the wafer 100 is diced between adjacent ones of the wafer portions 110 to separate the wafer 100 into the plurality of Time-of-Flight sensor devices 1.

### List of Reference Signs

- 1: Time-of-Flight sensor device
- 10: light detecting area
- 20: light detecting area
- 30: light emitter device
- 40: volume of light transparent material
- 50: volume of light transparent material
- 60: opaque material
- 70, 80: integrated circuit
- 90: through-silicon via
- 100: wafer
- 110: wafer portion
- 120: space between volumes of light transparent material
- 130: light transparent material
- 140: electrical connection/solder balls
- 150: die
- 160: optical filter
- 170: wire
- 200: imprint mold
- 210, 220: cavity of imprint mold
- 300: mold tool
- 310: body of mold tool
- 320: film

## Claims

1. A method for fabricating a plurality of Time-of-Flight sensor devices, comprising:
- providing a wafer (100) including a plurality of wafer portions (110) for a respective one of the Time-of-Flight sensor devices (1), wherein each of the wafer portions (110) includes a first light detecting area (10) and a second light detecting area (20), wherein at least the second light detecting area (20) is arranged in a surface (111) of the respective wafer portion (110),
- disposing a respective light emitter device (30) on each of the wafer portions (110), wherein the respective light emitter device (30) and the respective first light detecting area (10) are arranged so that portions of the light emitted by the respective light emitter device (30) are detected by the respective first light detecting area (10),
- encapsulating the respective light emitter device (30) and the respective first light detecting area (10) by a first volume (40) of a light transparent material (130), and encapsulating the respective second light detecting area (20) by a second volume (50) of the light transparent material (130), wherein the respective first and second volumes (40, 50) of the light transparent material (130) on the surface (111) of each wafer portion (110) are provided by a Nano Imprint Lithography process, wherein the first and second volume of the light transparent material are separated from each other, by the following steps a)-d):
a) providing an imprint mold (200) having a plurality of pairs of a first and a second cavity (210, 220), wherein each pair of the first and the second cavity (210, 220) is associated to a respective one of the Time-of-Flight sensor devices (1),
b) filling the first and the second cavity (210, 220) of each pair of the first and the second cavity with the light transparent material (130),
c) placing the imprint mold (200) on the surface (111) of each wafer portion (110) of the wafer (100) such that each pair of the first and the second cavity (210, 220) is placed over a respective one of the wafer portions (110),
d) curing the transparent material (130) in the first and the second cavity (210, 220) of each pair of the first and the second cavity to form the respective first and second volume (40, 50) of the light transparent material (130) of each Time-of-Flight sensor device, wherein the respective first cavity (210) of each pair of the first and the second cavity of the imprint mold (200) is shaped such that the first volume (40) of the light transparent material (130) is formed having a concave shape, and wherein the respective second cavity (220) of each pair of the first and the second cavity of the imprint mold (200) is shaped such that the second volume (50) of the light transparent material (130) is formed having a convex shape,
- placing an opaque material (60) on the wafer portions (110) in a space (120) between the respective first and second volume (40, 50) of the light transparent material (130),
- dicing the wafer (100) between adjacent ones of the wafer portions (110) to separate the wafer into the plurality of the Time-of-Flight sensor devices (1).

2. The method of claim 1, comprising:
- providing the wafer (100) of a silicon material,
- providing the wafer portions (110) of the wafer (100) including a respective first integrated circuit (70) coupled to the respective first light detecting area (10) to convert an optical signal of the respective first light detecting area in a first electrical signal,
- providing the wafer portions (110) of the wafer (100) including a respective second integrated circuit (80) coupled to the respective second light detecting area (20) to convert an optical signal of the respective second light detecting area (20) in a second electrical signal.

3. The method of claims 1 or 2,
wherein the respective light emitter device (30) and the respective first light detecting area (10) of each wafer portion (110) are arranged next to each other or on top of each other on the wafer (100) so that the portions of the light emitted by the respective light emitter device (30) are detected by the respective first light detecting area (10).

4. The method of claim 1,
wherein each pair of the first and the second cavity (210, 220) of the imprint mold (200) is placed over a respective one of the wafer portions (110) such that the light transparent material (130) filled in the first cavity (210) of the respective pair of the first and second cavity of the imprint mold is placed above the respective first light detecting area (10) and the respective light emitter device (30) to form the first volume (40) of the light transparent material (130) and the transparent material filled in the second cavity (220) of the respective pair of the first and second cavity of the imprint mold is placed above the respective second light detecting area (20) to form the second volume (50) of the light transparent material (130).

5. The method of claim 4,
wherein a respective surface (211, 221) at the bottom of the first and the second cavity (210, 220) of each pair of the first and the second cavity of the imprint mold (200) has a shape so that the first and the second volume (40, 50) of the light transparent material (130) is formed as a lens.

6. The method of any of the claims 1 to 5,
wherein the opaque material (60) is placed on the wafer portions (110) of the wafer (100) by a film-assisted wafer-level molding process.

7. The method of claim 6, comprising:
- providing a mold tool (300) having a body (310) covered by a film (320),
- placing the mold tool (300) above the wafer (100) such that a respective upper surface (41, 51) of the first and the second volume (40, 50) of the light transparent material (130) is covered by the film (320) and the space (120) is provided between the film (320) and the surface (111) of the wafer portions (110),
- injecting the opaque material (60) in the space (120) between the film (320) and the surface (111) of the wafer portions (110), wherein the film (320) seals the respective upper surface (41, 51) of the first and the second volume (40, 50) of the light transparent material (130) so that the respective upper surface (41, 51) of the first and the second volume (40, 50) of the light transparent material (130) is kept free of the opaque material (60).

8. The method of claim 7, comprising:
- providing the wafer (100) with respective through silicon vias (90) in the material of each of the wafer portions (110),
- mounting solder balls (140) to a bottom surface (112) of each wafer portion (110) of the wafer (100) to provide an electrical connection for each of the Time-of-Flight sensor devices (1).

9. A Time-of-Flight sensor device, comprising:
- a silicon die (150) including a first light detecting area (10) and a second light detecting area (20) being arranged in a surface (151) of the silicon die (150),
- a light emitter device (30) being arranged on the surface (151) of the silicon die (150) in relation to the first light detecting area (10) such that portions of the light emitted by the light emitter device (30) are detected by the first light detecting area (10),
- a first volume (40) of a light transparent material (130) being placed on the surface (151) of the silicon die (150) so that the light emitter device (30) and the first light detecting area (10) are encapsulated by the first volume (40) of the light transparent material (130),
- a second volume (50) of a light transparent material (130) being placed on the surface (151) of the silicon die (150) so that the second light detecting area (20) is encapsulated by the second volume (40) of the light transparent material (130), wherein the first and second volume (40, 50) of the light transparent material (130) are separated from each other,
- wherein an opaque material (60) is disposed in a space (120) between the first and second volume (40, 50) of the light transparent material (130) such that an upper surface (41, 51) of the first and the second volume (40, 50) of the light transparent material (130) is free from the opaque material (60), wherein the opaque material (60) prevents the second light sensitive surface (20) from receiving light directly emitted from the light emitter device (30), **characterized in that** a surface (41) of the first volume (40) of the light transparent material (130) is formed so that the first volume (40) of the light transparent material (130) is configured as a concave lens, and a surface (51) of the second volume (50) of the light transparent material (130) is formed so that the second volume (50) of the light transparent material (130) is configured as a convex lens.

10. The Time-of-Flight sensor device of claim 9,
- a first integrated circuit (70) coupled to the first light detecting area (10) to convert an optical signal received from the first light detecting area (10) in a first electrical signal,
- a second integrated circuit (80) coupled to the second light detecting area (20) to convert an optical signal received from the second light detecting area (20) in a second electrical signal,
- wherein the first and the second integrated circuit (70, 80) are embedded in the silicon die (150),
- through silicon vias (90) being provided in the silicon die (150) and filled with an electrically conductive material (91),
- solder balls (140) to electrically connect the first and second integrated circuit (70, 80) via the through silicon vias (90).

11. The Time-of-Flight sensor device of claim 9 or 10,
- wherein the light emitter device (30) and the first light detecting area (10) are arranged next to each other or on top of each other on the silicon die (150) so that the portions of the light emitted by the light emitter device (30) are detected by the first light detecting area (10),
- wherein the light emitter device (30) is configured as a VCSEL,
- wherein the first and the second light detecting area (10, 20) are configured as two specially separated SPAD arrays,
- wherein the light transparent material (130) of the first and the second volume (40, 50) includes a clear epoxy resin or silicone.

## Patentansprüche

1. Verfahren zur Herstellung einer Vielzahl von Laufzeitmess-Sensorvorrichtungen, umfassend:
- Bereitstellen eines Wafers (100) mit einer Vielzahl von Waferabschnitten (110) für jeweils eine der Laufzeitmess-Sensorvorrichtungen (1), wobei jeder der Waferabschnitte (110) einen ersten Lichtdetektionsbereich (10) und einen zweiten Lichtdetektionsbereich (20) aufweist, wobei zumindest der zweite Lichtdetektionsbereich (20) in einer Oberfläche (111) des jeweiligen Waferabschnitts (110) angeordnet ist,
- Anordnen einer jeweiligen Lichtemittervorrichtung (30) auf jedem der Waferabschnitte (110), wobei die jeweilige Lichtemittervorrichtung (30) und der jeweilige erste Lichtdetektionsbereich (10) so angeordnet sind, dass Teile des von der jeweiligen Lichtemittervorrichtung (30) emittierten Lichts von dem jeweiligen ersten Lichtdetektionsbereich (10) erfasst werden,
- Einkapseln der jeweiligen Lichtemittervorrichtung (30) und des jeweiligen ersten Lichtdetektionsbereichs (10) durch ein erstes Volumen (40) aus einem lichtdurchlässigen Material (130), und Einkapseln des jeweiligen zweiten Lichtdetektionsbereichs (20) durch ein zweites Volumen (50) des lichtdurchlässigen Materials (130), wobei die jeweiligen ersten und zweiten Volumina (40, 50) des lichtdurchlässigen Materials (130) auf der Oberfläche (111) jedes Waferabschnitts (110) durch ein Nanoimprint-Lithografieverfahren bereitgestellt werden, wobei das erste und das zweite Volumen des lichtdurchlässigen Materials durch die folgenden Schritte a) bis d) voneinander getrennt werden:
a) Bereitstellen einer Prägeform (200) mit einer Vielzahl von Paaren aus einem ersten und einem zweiten Hohlraum (210, 220), wobei jedes Paar aus dem ersten und dem zweiten Hohlraum (210, 220) einer jeweiligen der Laufzeitmess-Sensorvorrichtungen (1) zugeordnet ist,
b) Befüllen des ersten und des zweiten Hohlraums (210, 220) jedes Paares aus dem ersten und zweiten Hohlraum mit dem lichtdurchlässigen Material (130),
c) Anordnen der Prägeform (200) auf der Oberfläche (111) jedes Waferabschnitts (110) des Wafers (100) derart, dass jedes Paar aus dem erstem und zweitem Hohlraum (210, 220) über einem jeweiligen Waferabschnitt (110) angeordnet ist,
d) Aushärten des transparenten Materials (130) in dem ersten und der zweiten Hohlraum (210, 220) jedes Paares aus dem ersten und zweiten Hohlraum, um das jeweilige erste und zweite Volumen (40, 50) aus dem lichtdurchlässigen Material (130) jeder Laufzeitmess-Sensorvorrichtung zu formen, wobei der jeweilige erste Hohlraum (210) jedes Paares aus dem erstem und zweitem Hohlraum der Prägeform (200) derart geformt ist, dass der erste Hohlraum (40) des lichtdurchlässigen Materials (130) mit einer konkaven Form ausgebildet wird, und wobei der jeweilige zweite Hohlraum (220) jedes Paares aus dem ersten und zweiten Hohlraum der Prägeform (200) derart geformt ist, dass der zweite Bereich (50) des lichtdurchlässigen Materials (130) mit einer konvexen Form ausgebildet wird,
- Aufbringen eines lichtundurchlässigen Materials (60) auf die Waferabschnitte (110) in einem Zwischenraum (120) zwischen dem jeweiligen ersten und zweiten Volumen (40, 50) des lichtdurchlässigen Materials (130),
- Zerschneiden des Wafers (100) zwischen benachbarten der Waferabschnitte (110), um den Wafer in die Vielzahl von Laufzeitmess-Sensorvorrichtungen (1) zu trennen.

2. Verfahren nach Anspruch 1, umfassend:
- Bereitstellen des Wafers (100) aus einem Siliziummaterial,
- Bereitstellen der Waferabschnitte (110) des Wafers (100), die jeweils eine erste integrierte Schaltung (70) enthalten, die mit dem jeweiligen ersten Lichtdetektionsbereich (10) verbunden ist, um ein optisches Signal des jeweiligen ersten Lichtdetektionsbereichs in ein erstes elektrisches Signal umzuwandeln,
- Bereitstellen der Waferabschnitte (110) des Wafers (100), die jeweils eine zweite integrierte Schaltung (80) enthalten, die mit dem jeweiligen zweiten Lichtdetektionsbereich (20) verbunden ist, um ein optisches Signal des jeweiligen zweiten Lichtdetektionsbereichs (20) in ein zweites elektrisches Signal umzuwandeln.

3. Verfahren nach Anspruch 1 oder 2,
wobei die jeweilige Lichtemittervorrichtung (30) und der jeweilige erste Lichtdetektionsbereich (10) jedes Waferabschnitts (110) nebeneinander oder übereinander auf dem Wafer (100) angeordnet sind, so dass die von der jeweiligen Lichtemittervorrichtung (30) emittierten Lichtanteile von dem jeweiligen ersten Lichtdetektionsbereich (10) erfasst werden.

4. Verfahren nach Anspruch 1,
wobei jedes Paar aus dem ersten und dem zweiten Hohlraum (210, 220) der Prägeform (200) über einem jeweiligen der Waferabschnitte (110) derart angeordnet ist, dass das lichtdurchlässige Material (130), mit dem der erste Hohlraum (210) des jeweiligen Paares aus dem ersten und dem zweiten Hohlraum der Prägeform gefüllt ist, über dem jeweiligen ersten Lichtdetektionsbereich (10) und der jeweiligen Lichtemittervorrichtung (30) angeordnet ist, um das erste Volumen (40) des lichtdurchlässigen Materials (130) zu bilden, und das lichtdurchlässige Material, mit dem der zweite Hohlraum (220) des jeweiligen Paares aus dem ersten und dem zweitem Hohlraum der Prägeform gefüllt ist, über dem jeweiligen zweiten Lichtdetektionsbereich (20) angeordnet wird, um das zweite Volumen (50) des lichtdurchlässigen Materials (130) zu bilden.

5. Verfahren nach Anspruch 4,
wobei eine jeweilige Oberfläche (211, 221) am Boden des ersten und des zweiten Hohlraums (210, 220) jedes Paares aus dem ersten und zweiten Hohlraum der Prägeform (200) eine solche Form aufweist, dass das erste und das zweite Volumen (40, 50) des lichtdurchlässigen Materials (130) als Linse ausgebildet werden.

6. Verfahren nach einem der Ansprüche 1 bis 5,
wobei das lichtundurchlässige Material (60) mittels eines foliengestützten Wafer-Level-Formverfahrens auf die Waferabschnitte (110) des Wafers (100) aufgebracht wird.

7. Verfahren nach Anspruch 6, umfassend:
- Bereitstellen eines Formwerkzeugs (300) mit einem Körper (310), der von einer Folie (320) bedeckt ist,
- Anordnen des Formwerkzeugs (300) über dem Wafer (100) derart, dass eine jeweilige obere Oberfläche (41, 51) des ersten und des zweiten Volumens (40, 50) des lichtdurchlässigen Materials (130) von der Folie (320) bedeckt ist und der Zwischenraum (120) zwischen der Folie (320) und der Oberfläche (111) der Waferabschnitte (110) bereitgestellt wird,
- Einspritzen des lichtundurchlässigen Materials (60) in den Zwischenraum (120) zwischen der Folie (320) und der Oberfläche (111) der Waferabschnitte (110), wobei die Folie (320) die jeweilige Oberseite (41, 51) des ersten und des zweiten Volumens (40, 50) des lichtdurchlässigen Materials (130) abdichtet, so dass die jeweilige Oberseite (41, 51) des ersten und des zweiten Volumens (40, 50) des lichtdurchlässigen Materials (130) frei von dem lichtundurchlässigen Material (60) bleibt.

8. Verfahren nach Anspruch 7, umfassend:
- Bereitstellen des Wafers (100) mit jeweiligen Durchkontaktierungen (90) im Material jedes der Waferabschnitte (110),
- Anbringen von Lötkugeln (140) an einer Unterseite (112) jedes Waferabschnitts (110) des Wafers (100), um eine elektrische Verbindung für jede der Laufzeitmess-Sensorvorrichtungen (1) herzustellen.

9. Laufzeitmess-Sensoreinrichtung, umfassend:
- einen Siliziumchip (150) mit einem ersten Lichtdetektionsbereich (10) und einem zweiten Lichtdetektionsbereich (20), die in einer Oberfläche (151) des Siliziumchips (150) angeordnet sind,
- eine Lichtemittervorrichtung (30), die auf der Oberfläche (151) des Siliziumchips (150) in Bezug auf den ersten Lichtdetektionsbereich (10) derart angeordnet ist, dass Teile des von der Lichtemittervorrichtung (30) emittierten Lichts von dem ersten Lichtdetektionsbereich (10) erfasst werden,
- ein erstes Volumen (40) aus einem lichtdurchlässigen Material (130), das auf der Oberfläche (151) des Siliziumchips (150) derart angeordnet ist, dass die Lichtemittervorrichtung (30) und der erste Lichtdetektionsbereich (10) von dem ersten Volumen (40) aus dem lichtdurchlässigen Material (130) umschlossen sind,
- ein zweites Volumen (50) aus einem lichtdurchlässigen Material (130), das auf der Oberfläche (151) des Siliziumchips (150) derart angeordnet ist, dass der zweite Lichtdetektionsbereich (20) durch das zweite Volumen (40) des lichtdurchlässigen Materials (130) eingekapselt ist, wobei das erste und das zweite Volumen (40, 50) des lichtdurchlässigen Materials (130) voneinander getrennt sind,
- wobei ein lichtundurchlässiges Material (60) in einem Zwischenraum (120) zwischen dem ersten und dem zweiten Volumen (40, 50) des lichtdurchlässigen Materials (130) derart angeordnet ist, dass eine Oberseite (41, 51) des ersten und des zweiten Volumens (40, 50) des lichtdurchlässigen Materials (130) frei von dem lichtundurchlässigen Material (60) ist, wobei das lichtundurchlässige Material (60) verhindert, dass die zweite lichtempfindliche Oberfläche (20) Licht empfängt, das direkt von der Lichtemittiervorrichtung (30) emittiert wird, **dadurch gekennzeichnet, dass** eine Oberseite (41) des ersten Volumens (40) des lichtdurchlässigen Materials (130) derart ausgebildet ist, dass das erste Volumen (40) des lichtdurchlässigen Materials (130) als konkave Linse ausgebildet ist, und eine Oberseite (51) des zweiten Volumens (50) des lichtdurchlässigen Materials (130) derart ausgebildet ist, dass der zweite Körper (50) aus dem lichtdurchlässigen Material (130) als konvexe Linse ausgebildet ist.

10. Laufzeitmess-Sensorvorrichtung nach Anspruch 9,
- eine erste integrierte Schaltung (70), die mit dem ersten Lichtdetektionsbereich (10) verbunden ist, um ein von dem ersten Lichtdetektionsbereich (10) empfangenes optisches Signal in ein erstes elektrisches Signal umzuwandeln,
- eine zweite integrierte Schaltung (80), die mit dem zweiten Lichtdetektionsbereich (20) verbunden ist, um ein von dem zweiten Lichtdetektionsbereich (20) empfangenes optisches Signal in ein zweites elektrisches Signal umzuwandeln,
- wobei die erste und die zweite integrierte Schaltung (70, 80) in den Siliziumchip (150) eingebettet sind,
- Durchkontaktierungen (90), die in dem Siliziumchip (150) vorgesehen sind und mit einem elektrisch leitfähigen Material (91) gefüllt sind,
- Lötkugeln (140) zur elektrischen Verbindung der ersten und der zweiten integrierten Schaltung (70, 80) über die Durchkontaktierungen (90).

11. Laufzeitmess-Sensorvorrichtung nach Anspruch 9 oder 10,
- wobei die Lichtemittervorrichtung (30) und der erste Lichtdetektionsbereich (10) nebeneinander oder übereinander auf dem Siliziumchip (150) angeordnet sind, sodass die Anteile des von der Lichtemittervorrichtung (30) emittierten Lichts von dem ersten Lichtdetektionsbereich (10) erfasst werden,
- wobei die Lichtemittervorrichtung (30) als VCSEL ausgebildet ist,
- wobei der erste und der zweite Lichtdetektionsbereich (10, 20) als zwei speziell voneinander getrennte SPAD-Arrays ausgebildet sind,
- wobei das lichtdurchlässige Material (130) des ersten und des zweiten Volumens (40, 50) ein klares Epoxidharz oder Silikon umfasst.

## Revendications

1. Un procédé de fabrication d'une pluralité de dispositifs capteurs à temps de vol, comprenant:
- fournir une plaquette (100) comprenant une pluralité de portions de plaquette (110) destinées à chacun des dispositifs capteurs à temps de vol (1), sachant que chacune des portions de plaquette (110) comprend une première zone de détection de lumière (10) et une deuxième zone de détection de lumière (20), au moins la deuxième zone de détection de lumière (20) étant disposée sur une surface (111) de la zone de plaquette (110) respective,
- disposer un dispositif émetteur de lumière (30) respectif sur chacune des zones de plaquette (110), le dispositif émetteur de lumière (30) respectif et la première zone de détection de lumière (10) respective étant agencés de telle sorte que des parties de la lumière émise par le dispositif émetteur de lumière (30) respectif soient détectées par la première zone de détection de lumière (10) respective,
- encapsuler le dispositif émetteur de lumière (30) respective et la première zone de détection de lumière (10) respective dans un premier volume (40) d'un matériau transparent à la lumière (130), et encapsuler la deuxième zone de détection de lumière respective (20) dans un deuxième volume (50) du matériau transparent à la lumière (130), les premier et deuxième volumes respectifs (40, 50) du matériau transparent à la lumière (130) sur la surface (111) de chaque zone de plaquette (110) sont réalisés par un procédé de lithographie par nano-impression, sachant que les premier et deuxième volumes du matériau transparent à la lumière sont séparés l'un de l'autre, par les étapes a) à d) suivantes :
a) fournir un moule d'impression (200) comportant une pluralité de paires d'une première et d'une deuxième cavité (210, 220), sachant que chaque paire de première et deuxième cavités (210, 220) est associée à l'un respectif des dispositifs capteurs à temps de vol (1),
b) remplir les première et deuxième cavités (210, 220) de chaque paire de cavités avec le matériau transparent à la lumière (130),
c) placer le moule d'empreinte (200) sur la surface (111) de chaque zone de plaquette (110) de la plaquette (100) de telle sorte que chaque paire de première et deuxième cavités (210, 220) soit positionnée au-dessus d'une zone respective parmi les zones de plaquette (110),
d) durcir le matériau transparent (130) dans les première et deuxième cavités (210, 220) de chaque paire de première et deuxième cavités afin de former les premier et deuxième volumes respectifs (40, 50) du matériau transparent à la lumière (130) de chaque dispositif capteur à temps de vol, sachant que la première cavité respective (210) de chaque paire de première et deuxième cavités du moule d'empreinte (200) est formée de telle sorte que le premier volume (40) du matériau transparent à la lumière (130) soit formé avec une forme concave, et sachant que la deuxième cavité respective (220) de chaque paire de première et deuxième cavités du moule d'empreinte (200) est formée de telle sorte que le deuxième volume (50) du matériau transparent (130) présente une forme convexe,
- placer un matériau opaque (60) sur les zones de plaquette (110) dans un espace (120) situé entre les premier et deuxième volumes respectifs (40, 50) du matériau transparent (130),
- découper la plaquette (100) entre des zones adjacentes de la plaquette (110) afin de séparer la plaquette en une pluralité de dispositifs capteurs à temps de vol (1).

2. Le procédé selon la revendication 1, comprenant:
- fournir la plaquette (100) en silicium,
- fournir les zones de plaquette (110) de la plaquette (100) comprenant chacune un premier circuit intégré (70) couplé à une première zone de détection de lumière (10) respective afin de convertir un signal optique de ladite première zone de détection de lumière respective en un premier signal électrique,
- fournir les zones de plaquette (110) de la plaquette (100) comprenant un deuxième circuit intégré respectif (80) couplé à la deuxième zone de détection de lumière respective (20) afin de convertir un signal optique de ladite deuxième zone de détection de lumière respective (20) en un deuxième signal électrique.

3. Le procédé selon la revendication 1 ou 2,
sachant que le dispositif émetteur de lumière (30) et la première zone de détection de lumière (10) respectifs de chaque zone de plaquette (110) sont disposés l'un à côté de l'autre ou l'un au-dessus de l'autre sur la plaquette (100) de sorte que les parties de la lumière émise par le dispositif émetteur de lumière (30) respectif soient détectées par la première zone de détection de lumière (10) respective.

4. Le procédé selon la revendication 1,
sachant que chaque paire de première et deuxième cavités (210, 220) du moule d'empreinte (200) est placée au-dessus d'une zone respective parmi les zones de plaquette (110) de telle sorte que le matériau transparent à la lumière (130) remplissant la première cavité (210) de la paire respective de première et deuxième cavités du moule d'empreinte soit placé au-dessus de la première zone de détection de lumière respective (10) et au-dessus du dispositif émetteur de lumière (30) respectif afin de former le premier volume (40) de matériau transparent à la lumière (130), et le matériau transparent remplissant la deuxième cavité (220) de la paire respective de première et deuxième cavités du moule d'impression soit placé au-dessus de la deuxième zone de détection de lumière (20) afin de former le deuxième volume (50) du matériau transparent à la lumière (130).

5. Le procédé selon la revendication 4,
sachant qu'une surface respective (211, 221) située au fond des première et deuxième cavités (210, 220) de chaque paire de première et deuxième cavités du moule d'empreinte (200) présente une forme telle que les premier et deuxième volumes (40, 50) du matériau transparent à la lumière (130) soient formés en tant que lentilles.

6. Le procédé selon l'une quelconque des revendications 1 à 5,
sachant que le matériau opaque (60) est déposé sur les zones de plaquette (110) de la plaquette (100) par un procédé de moulage au niveau de la plaquette assisté par film.

7. Le procédé selon la revendication 6, comprenant:
- fournir un outil de moulage (300) comportant un corps (310) recouvert d'un film (320),
- placer l'outil de moulage (300) au-dessus de la plaquette (100) de telle sorte qu'une surface supérieure respective (41, 51) des premier et deuxième volumes (40, 50) du matériau transparent à la lumière (130) soit recouverte par le film (320) et qu'un espace (120) soit formé entre le film (320) et la surface (111) des zones de plaquette (110),
- injecter le matériau opaque (60) dans l'espace (120) entre le film (320) et la surface (111) des zones de la plaquette (110), le film (320) scellant les surfaces supérieures respectives (41, 51) des premier et deuxième volumes (40, 50) du matériau transparent à la lumière (130), de sorte que les surfaces supérieures respectives (41, 51) des premier et deuxième volumes (40, 50) du matériau transparent à la lumière (130) restent exemptes de matériau opaque (60).

8. Le procédé selon la revendication 7, comprenant:
- fournir la plaquette (100) avec des vias traversants en silicium (90) respectifs dans le matériau de chacune des zones de plaquette (110),
- monter de billes de soudure (140) sur une surface inférieure (112) de chaque zone de plaquette (110) de la plaquette (100) afin d'assurer une connexion électrique pour chacun des dispositifs capteurs à temps de vol (1).

9. Un dispositif de détection à temps de vol, comprenant:
- une puce de silicium (150) comprenant une première zone de détection de lumière (10) et une deuxième zone de détection de lumière (20) disposées sur une surface (151) de la puce de silicium (150),
- un dispositif émetteur de lumière (30) disposé sur la surface (151) de la puce en silicium (150) par rapport à la première zone de détection de lumière (10), de telle sorte que des parties de la lumière émise par le dispositif émetteur de lumière (30) soient détectées par la première zone de détection de lumière (10),
- un premier volume (40) d'un matériau transparent à la lumière (130) étant placé sur la surface (151) de la puce de silicium (150) de telle sorte que le dispositif émetteur de lumière (30) et la première zone de détection de lumière (10) soient encapsulés par le premier volume (40) du matériau transparent à la lumière (130),
- un deuxième volume (50) d'un matériau transparent à la lumière (130) étant placé sur la surface (151) de la puce de silicium (150) de telle sorte que la deuxième zone de détection de lumière (20) soit encapsulée par le deuxième volume (40) du matériau transparent à la lumière (130), les premier et deuxième volumes (40, 50) du matériau transparent à la lumière (130) étant séparés l'un de l'autre,
- sachant qu' un matériau opaque (60) est disposé dans un espace (120) entre les premier et deuxième volumes (40, 50) du matériau transparent (130) de telle sorte qu'une surface supérieure (41, 51) des premier et deuxième volumes (40, 50) du matériau transparent à la lumière (130) soit exempte de matériau opaque (60), le matériau opaque (60) empêchant la deuxième surface photosensible (20) de recevoir la lumière émise directement par le dispositif émetteur de lumière (30), **caractérisé en ce qu'**une surface (41) du premier volume (40) du matériau transparent à la lumière (130) est formée de telle sorte que le premier volume (40) du matériau transparent à la lumière (130) soit configuré comme une lentille concave, et qu'une surface (51) du deuxième volume (50) du matériau transparent à la lumière (130) est formée de telle sorte que le deuxième volume (50) du matériau transparent à la lumière (130) présente la forme d'une lentille convexe.

10. Le dispositif de détection à temps de vol selon la revendication 9,
- un premier circuit intégré (70) couplé à la première zone de détection de lumière (10) pour convertir un signal optique reçu de la première zone de détection de lumière (10) en un premier signal électrique,
- un deuxième circuit intégré (80) couplé à la deuxième zone de détection de lumière (20) pour convertir un signal optique reçu de la deuxième zone de détection de lumière (20) en un deuxième signal électrique,
- sachant que les premier et deuxième circuits intégrés (70, 80) sont intégrés dans la puce de silicium (150),
- des vias traversant le silicium (90) étant prévus dans la puce de silicium (150) et remplis d'un matériau électriquement conducteur (91),
- des billes de soudure (140) pour relier électriquement les premier et deuxième circuits intégrés (70, 80) via les vias traversants en silicium (90).

11. Le dispositif capteur à temps de vol selon la revendication 9 ou 10,
- sachant que le dispositif émetteur de lumière (30) et la première zone de détection de lumière (10) sont disposés l'un à côté de l'autre ou l'un au-dessus de l'autre sur la puce de silicium (150) de telle sorte que les parties de la lumière émise par le dispositif émetteur de lumière (30) soient détectées par la première zone de détection de lumière (10),
- sachant que le dispositif émetteur de lumière (30) est configuré comme un VCSEL,
- sachant que les première et deuxième zones de détection de lumière (10, 20) sont configurées comme deux réseaux de SPAD spécialement séparés,
- sachant que le matériau transparent à la lumière (130) des premier et deuxième volumes (40, 50) comprend une résine époxy transparente ou du silicone.
